# EUROPÄISCHE PATENTSCHRIFT

(11) **EP 3 058 597 B1**
(45) Veröffentlichungstag und Bekanntmachung des Hinweises auf die Patenterteilung: **20.09.2017**
(21) Anmeldenummer: 14786845.9
(22) Anmeldetag: 16.10.2014
(51) Int. Cl.: H01L 31/048

(54) **PHOTOVOLTAIK-PANEEL UND VERFAHREN ZU DESSEN HERSTELLUNG**
PHOTOVOLTAIC PANEL AND METHOD FOR ITS PRODUCTION
PANNEAU PHOTOVOLTAÏQUE ET SON PROCÉDÉ DE FABRICATION

(30) Priorität: 17.10.2013 EP 13189147
(43) Veröffentlichungstag der Anmeldung: 24.08.2016
(73) Patentinhaber: DAS Energy GmbH, 2700 Wiener Neustadt (AT)
(72) Erfinder: DRIES, Christian, A-2700 Wiener Neustadt (AT); ZIPPER, Manfred, A-2811 Wiesmath (AT); KRASNIK, Boris, A-2753 Markt Piesting (AT); HARTER, Johann, 01109 Dresden (DE)
(74) Vertreter: Sonn & Partner Patentanwälte
(86) Internationale Anmeldenummer: PCT/EP2014/072179
(87) Internationale Veröffentlichungsnummer: WO 2015/055750

(56) Entgegenhaltungen:
- EP-A2- 0 118 797
- WO-A1-2013/147102
- US-A- 4 104 083
- US-A1- 2010 292 378
- US-A1- 2012 024 348

## Beschreibung

Die vorliegende Erfindung betrifft ein Photovoltaik-Paneel mit zumindest einer Solarzelle, welche zumindest an ihrer dem Licht zugewandten Seite und ihrer gegenüberliegenden, dem Licht abgewandten Seite mit einem transparenten Verbundmaterial bedeckt ist. Die vorliegende Erfindung betrifft weiters ein Verfahren zur Herstellung des Photovoltaik-Paneels.

Photovoltaik-Paneele zur Gewinnung von elektrischer Energie aus Sonnenstrahlung sind allgemein bekannt. Für die Umwandlung der Sonnenstrahlung in elektrische Energie weisen diese Paneele Solarzellen, insbesondere speziell modifizierte anorganische Halbleiter bzw. Halbleiterwafer auf, die meist aus entsprechend dotiertem Silizium gefertigt und zu Modulen verknüpft werden. Es ist auch bekannt, organische Halbleiter oder aufgedampfte dünne halbleitende Schichten enthaltend Cadmium-Tellurid, Kupfer/Indium/(di)Selenid oder Kupfer/Indium/Gallium/Sulfid/Selenid oder amorphes Silizium zu nutzen. Die Module werden mittels entsprechender Einrichtungen laminiert, in Gehäuse eingebaut und zum Schutz vor Umwelteinflüssen, wie z.B. Regen und Schnee, mit einer Glasplatte abgedeckt. Die auf diese Weise erzeugten Photovoltaik-Paneele können an für die Umwandlung der Sonneneinstrahlung in elektrische Energie geeigneten Orten montiert werden. Die Photovoltaik-Paneele sind im allgemeinen jedoch starr, im Wesentlichen unflexibel und mit hohem Gewicht ausgebildet, wobei deren Gewicht vor allem durch das Gehäuse und die Abdeckung der photovoltaischen Module bestimmt wird.

Aus dem Stand der Technik sind Photovoltaik-Paneele bekannt, welche hinsichtlich einiger dieser Nachteile bereits verbessert sind.

Aus der WO 2013/119113 A1 ist ein Photovoltaik-Paneel bekannt, dessen Solarzellen vor Umwelteinflüssen, beispielsweise mechanischer Beschädigung, durch eine Umhüllung aus transparentem Verbundmaterial geschützt sind, welches ein faserverstärktes thermoplastisches Polymer, insbesondere Polymethylmethacrylat aufweist. Für die Herstellung wird das Paneel mit einem Gewebe aus Verstärkungsfasern auf eine Form aufgelegt und in die Form flüssiges thermoplastisches Polymer bei 150 bis 250°C und einem Druck von 1 bis 500 bar eingeleitet. Das Paneel kann im Vergleich zu Paneelen mit einer Abdeckung aus Glas dünner und mit geringerem Gewicht hergestellt werden und weist hohe mechanische Festigkeit auf. Um unebene bzw. gebogene Paneele herzustellen sind jedoch entsprechend ausgebildete Gießformen erforderlich.

Die DT 24 45 642 A1 betrifft einen Solarzellengenerator, wobei die Solarzellen und ihre Verbindungselemente allseitig von einem einzigen Werkstoff umgeben sind. Als Werkstoffe sind Polyesterharz, Acrylharz, polymeres Acryl-Polyester und Epoxyharz mit oder ohne Glasfaserverstärkung sowie thermoplastischer Kunststoff aus der Reihe der Polykarbonate genannt. Für die Herstellung werden die Solarzellen auf eine mit Kunstharz getränkte Glasfaserschicht aufgelegt und mit einer zweiten, mit demselben Kunstharz getränkte Glasfaserschicht abgedeckt, sodass die Solarzellen nach der Aushärtung des Kunstharzes von einer einheitlichen Umhüllung umschlossen sind. Die Druckschrift offenbart jedoch keine Details hinsichtlich der Festigkeit, der Dicke oder des Gewichts des Solarzellengenerators.

Die EP 0 071 181 A2 offenbart ein biegsames photovoltaisches Solarmodul mit Solarzellen. Hierbei werden zumindest die Solarzellen zu deren Schutz mit flächenförmigen Versteifungen unterlegt und/oder mit einer versteifenden Dünnglasschicht überdeckt, während der übrige Teil der Solarmodulfläche nicht versteift wird. Das Solarmodul weist ein flexibles Tragelement auf, wie beispielsweise ein Metallgewebe, einen faserverstärkten flexiblen Verbundwerkstoff oder eine verstärkte Kunststofffolie. Die Solarzellen werden von Kunststofffolien oder flexiblen Verbundwerkstoffen umgeben. Nachteilig ist hierbei der aufwändige Aufbau und eine nur eingeschränkte Flexibilität des Solarmoduls.

Die US 2012/0024348 A1 offenbart die Verwendung von nonwoven Glasfasermatten (scrim) bei der Herstellung von Photovoltaik-Paneelen, welche nicht gewobenen Glasfasermatten als Schicht zwischen den Solarzellen und den Verstärkungsschichten vorgesehen werden.

Auch die EP 0 118 797 A2 offenbart ein Photovoltaik-Paneel (Solarzelle), bei dem das Einbettungsmaterial für die Solarzellen aus einem transparenten glasfaserverstärktem Harz besteht, wobei Glasfasermatten mit Harz getränkt und unter Einschluss der Zellen zusammengefügt und danach ausgewertet werden. Ein spezifisches Harz wird nicht geoffenbart.

Die WO 2103/147102 A1 beschreibt Harze für Photovoltaik-Paneele. Glasfasermatten oder andere Verstärkungsmaterialien werden an keiner Stelle erwähnt.

Die US 2010/292378 A1 schließlich offenbart, dass es bei Verwendung von Glasgeweben (glass cloth) als Füllstoff zur Verbesserung von mechanischen Eigenschaften des Einbettungsmaterials bei fortlaufendem Erhitzen und Abkühlen zu Mikrorissen im Material kommt, wodurch die Transparenz des Materials verloren geht. Als Lösung wird eine Dispersion aus synthetischem Smectit, einer Vinylesterharzzusammensetzung und einem Lösungsmittel vorgeschlagen, mit welcher beispielsweise eine glatte Glasoberfläche beschichtet werden kann. Das Vorsehen von Verstärkungsmaterialien in einer solchen Dispersion wird nicht geoffenbart.

Es ist nun eine Aufgabe der Erfindung, ein Photovoltaik-Paneel bereitzustellen, welches die Nachteile des Standes der Technik vermeidet oder zumindest reduziert und ein geringes Gewicht und eine geringe Dicke aufweist. Insbesondere soll das Photovoltaik-Paneel möglichst flexibel ausgebildet und die Solarzellen vor Umwelteinflüssen, wie mechanischer Beschädigung, beispielsweise durch Hagel, geschützt sein. Zudem soll das Paneel einen möglichst hohen Wirkungsgrad aufweisen und einfach und kostengünstig herstellbar sein.

Die Aufgabe wird erfindungsgemäß dadurch gelöst, dass das Photovoltaik-Paneel mit zumindest einer Solarzelle, welche zumindest an ihrer dem Licht zugewandten Seite und ihrer gegenüberliegenden, dem Licht abgewandten Seite mit einem transparenten Verbundmaterial bedeckt ist, dadurch gekennzeichnet ist, dass das Verbundmaterial ein mit Glasfasern verstärkter Kunststoff auf Basis eines Acrylats enthaltend Epoxigruppen ist, wobei die Glasfasern an der dem Licht zugewandten Seite der zumindest einen Solarzelle zu einem Gewebe mit einem Gewicht im Bereich von 50 bis 300 g/m², vorzugsweise im Bereich von 100 bis 200 g/m² und besonders bevorzugt im Bereich von 160 bis 165 g/m² ausgebildet sind. Die zumindest eine Solarzelle ist somit an ihrer Vorderseite und ihrer Rückseite mit dem Verbundmaterial im Wesentlichen vollständig bedeckt. Vorzugsweise ist die zumindest eine Solarzelle vollständig von dem Verbundmaterial eingeschlossen. Wenn im weiteren Verlauf dieser Beschreibung auf eine Solarzelle Bezug genommen wird, ist hiermit jenes photovoltaisch aktive Element gemeint, welches das auf seine Oberfläche einfallende Sonnenlicht in elektrische Energie umwandelt. Weiters wird unter der dem Licht zugewandten Seite jene Seite der Solarzelle bzw. des Photovoltaik-Paneels verstanden, die bei bestimmungsgemäßer Verwendung des Photovoltaik-Paneels der Sonneneinstrahlung zugewandt ist. Selbstverständlich kann auch auf die dem Licht abgewandten Seite (Rückseite) Licht auftreffen, wenn diese nicht lichtundurchlässig abgedeckt ist. Auch können mehrere Solarzellen zu einem Modul zusammengeschlossen und von dem Verbundmaterial bedeckt bzw. darin eingeschlossen sein. Wenn in dieser Beschreibung auf Glasfasern Bezug genommen wird, sind hiermit allgemein transparente Verstärkungsfasern gemeint, welche die erforderliche Festigkeit aufweisen, um den Kunststoff auf Basis eines Acrylats enthaltend Epoxygruppen zu verstärken. Demnach müssen im Rahmen dieser Beschreibung die als Glasfasern bezeichneten Verstärkungsfasern nicht notwendigerweise aus Glas hergestellt sein. Inbesondere können die Glasfasern aus einem transparenten Kunststoff bestehen, welcher im Wesentlichen den gleichen optischen Brechungsindex wie der Kunststoff auf Basis eines Acrylats enthaltend Epoxygruppen aufweist. Die Glasfasern im Verbundmaterial bewirken eine mechanische Verstärkung des Paneels, begünstigen jedoch durch ihre Transparenz auch eine hohe Lichtdurchlässigkeit des Verbundmaterials. Sowohl die Glasfasern als auch der Kunststoff auf Basis eines Acrylats enthaltend Epoxigruppen bewirken eine ausreichende elektrische Isolierung der von dem Verbundmaterial umgebenen stromführenden Komponenten des Paneels. Durch das Verbundmaterial werden die hiermit bedeckten bzw. vollständig eingehüllten Komponenten gegenüber der Umgebung abgedichtet Durch die Ausbildung der Glasfasern zu einem Gewebe wird die Belastbarkeit des Verbundmaterials und somit des Paneels erhöht. Zudem ist mit einem derart leichten Gewebe auch ein Paneel mit geringem Gewicht herstellbar. Insbesondere wird dem Paneel hohe Festigkeit und hohe Widerstandsfähigkeit auch gegenüber mechanischen Umwelteinflüssen verliehen. Seine hohe Schlagzähigkeit bietet geeigneten Schutz, beispielsweise vor Hagel oder anderen mechanischen Einflüssen. Ein eigenes Gehäuse, in welches die Module zur Erzielung der geforderten Festigkeit und zum Schutz vor Umwelteinflüssen eingebaut werden müssen, bzw. die Abdeckung mit einer Glasplatte ist somit nicht erforderlich. Das erfindungsgemäße Paneel kann insbesondere besonders dünn und mit geringem Gewicht hergestellt werden. Auf Grund der hohen Transparenz des Verbundmaterials wird zudem ein hoher Wirkungsgrad des Paneels erzielt. Überraschender Weise wird die Transparenz des Verbundmaterials von den Epoxigruppen im Wesentlichen nicht beeinflusst. Besonders vorteilhaft ist, dass das Paneel auch flexibel ist, sodass es einfach in die Form unterschiedlicher unebener Flächen, an denen es aufliegen soll, gebracht werden kann. Das Paneel kann weitere Schichten, beispielsweise organische polymere Materialien, zur weiteren Verbesserung des Schutzes vor Umwelteinflüssen auf seiner Vorderseite und/oder Rückseite aufweisen. So kann auf der dem Licht zugewandten Vorderseite eine ETFE (Ethylen-Tetrafluorethylen) Folie und auf der dem Licht abgewandten Rückseite eine EPE (EVA - Polyester - EVA) Filmschicht aufgebracht sein. Weiters können zusätzliche Polymerschichten zwischen den einzelnen Materialien eingefügt werden, wie beispielsweise eine Schicht aus EVA (Ethylenvinylacetat), zwischen der dem Licht zugewandten Seite der Solarzellen und der an der Vorderseite des Paneels angeordneten Schicht aus Verbundmaterial.

Gemäß einer bevorzugten Ausführungsform der vorliegenden Erfindung ist das Acrylat enthaltend Epoxigruppen Glycidylmethacrylat.

Wenn die Glasfasern einen Filamentdurchmesser im Bereich von 3 bis 15 µm, vorzugsweise im Bereich von 6 bis 12 µm und besonders bevorzugt von 9 µm aufweisen, kann die durch die Glasfasern gebildete Verstärkungsschicht und somit auch die Schicht aus Verbundmaterial besonders dünn und flexibel und mit geringem Gewicht ausgebildet sein.

Vorzugsweise sind die Glasfasern an der dem Licht zugewandten Seite der zumindest einen Solarzelle zu einem Gewebe mit einem Gewicht im Bereich von 50 bis 300 g/m², vorzugsweise im Bereich von 100 bis 200 g/m² und besonders bevorzugt im Bereich von 160 bis 165 g/m², ausgebildet. Durch die Ausbildung der Glasfasern zu einem Gewebe wird die Belastbarkeit des Verbundmaterials und somit des Paneels erhöht. Zudem ist mit einem derart leichten Gewebe auch ein Paneel mit geringem Gewicht herstellbar.

Besonders bevorzugt weist das Gewebe an der dem Licht zugewandten Seite der zumindest einen Solarzelle einen Kettgarn und einen Schussgarn mit einer Feinheit im Bereich von 30 bis 120 tex, vorzugsweise im Bereich von 45 bis 100 tex und besonders bevorzugt im Bereich von 60 bis 70 tex auf. Unter einem tex wird hierbei 1 Gramm pro 1000 Meter verstanden. Ein derartiges Gewebe ermöglicht eine dünne und leichte Ausbildung des Verbundmaterials an der dem Licht zugewandten Seite der zumindest einen Solarzelle.

Gemäß einer weiteren bevorzugten Ausführungsform der Erfindung sind die Glasfasern an der dem Licht abgewandten Seite der zumindest einen Solarzelle zu einem Gewebe mit einem Gewicht im Bereich von 100 bis 600 g/m², vorzugsweise im Bereich von 200 bis 500 g/m² und besonders bevorzugt von 390 g/m² ausgebildet. Das an der dem Licht abgewandten Seite der zumindest einen Solarzelle angeordnete Gewebe kann insbesondere schwerer und somit auch fester ausgebildet sein, als das an der dem Licht zugewandten Seite der zumindest einen Solarzelle angeordnete Gewebe. Auf diese Weise kann das Paneel an der Rückseite eine besonders feste Verstärkung aufweisen, während das durch die Vorderseite des Paneels auf die Solarzellen einfallende Licht die dünnere Gewebeschicht mit möglichst geringen Verlusten durchdringt.

Vorzugsweise weist das Gewebe an der dem Licht abgewandten Seite der zumindest einen Solarzelle einen aus 1 bis 9, vorzugsweise 3 bis 7, besonders bevorzugt 5 zusammengelegten Garnen bestehenden Kettgarn mit einer Feinheit der Garne im Bereich von 30 bis 120 tex, vorzugsweise im Bereich von 45 bis 100 tex und besonders bevorzugt im Bereich von 60 bis 70 tex und einen Schussgarn mit einer Feinheit im Bereich von 100 bis 450 tex, vorzugsweise im Bereich von 200 bis 350 tex und besonders bevorzugt im Bereich von 270 bis 280 tex auf. Durch das Zusammenlegen mehrerer Garne zu einem Kettgarn wird dessen Festigkeit erhöht. Die Feinheit des Kettgarns und Schussgarns ermöglicht zudem eine dünne Ausbildung des Verbundmaterials an der dem Licht abgewandten Seite der zumindest einen Solarzelle.

Die Aufgabe wird erfindungsgemäß weiters dadurch gelöst, dass ein Verfahren zur Herstellung des vorstehend beschriebenen Photovoltaik-Paneels die folgenden Schritte umfasst:
- Aufbringen von pulverförmigem Acrylat enthaltend Epoxigruppen auf ein erstes Gewebe aus Glasfasern,
- Auflegen zumindest einer Solarzelle und mit der Solarzelle verbundener elektrischer Anschlussleitungen sowie allfälliger mehrere Solarzellen verbindende Verbindungsleitungen auf das pulverförmige Acrylat enthaltend Epoxigruppen oder auf eine auf das pulverförmige Acrylat enthaltend Epoxigruppen aufgebrachte Schicht aus Ethylenvinylacetat,
- Auflegen eines zweiten Gewebes aus Glasfasern auf die zumindest eine Solarzelle, die Anschlussleitungen und die allfälligen Verbindungsleitungen,
- Aufbringen von pulverförmigem Acrylat enthaltend Epoxigruppen auf das zweite Gewebe, und
Laminieren des gesamten Aufbaus.

Durch das Laminieren wird das pulverförmige Acrylat enthaltend Epoxigruppen aufgeschmolzen und ist transparent und die einzelnen Schichten des Aufbaus werden miteinander verbunden. Gemäß diesem Verfahren ist die zumindest eine Solarzelle bzw. sind die Solarzellen nach dem Laminieren an der dem Licht zugewandten und der dem Licht abgewandten Seite mit einem transparenten Verbundmaterial bedeckt bzw. von dem Verbundmaterial eingeschlossen. Zudem sind auch die Anschlussleitungen der Solarzelle(n) und allfällige mehrere Solarzellen verbindende Verbindungsleitungen zumindest teilweise mit dem transparenten Verbundmaterial umgeben. Das Verbundmaterial weist hierbei das jeweilige Glasfasergewebe und das Acrylat enthaltend Epoxigruppen auf. Der Aufbau ist einfach und kostengünstig herzustellen. Das pulverförmige Acrylat enthaltend Epoxigruppen wird bevorzugt mit einem Pulverstreuer auf das jeweilige Gewebe aufgebracht und kann zudem geeignet dosiert werden. Das Acrylat enthaltend Epoxigruppen kann hierbei teilweise in die Maschenöffnungen des Gewebes eindringen und hierdurch beim Laminieren besser um die Glasfasern des Gewebes herum schmelzen. Es sei darauf hingewiesen, dass das Pulver sehr kleine Korngrößen aufweisen kann und daher der Begriff "Pulver" auch ein "Puder" mit umfassen kann. Zwischen dem auf das erste Gewebe aufgebrachten pulverförmigen Acrylat enthaltend Epoxigruppen und der Solarzelle bzw. ihren Anschlussleitungen und allfälligen Verbindungsleitungen kann zudem eine Schicht aus Ethylenvinylacetat als zusätzlicher Schutz vor Umwelteinflüssen vorgesehen werden.

Besonders bevorzugt erfolgt das Laminieren in einem Temperaturbereich von 150 bis 200°C, bei einem Druck von bis zu 500 mbar und unter einem Vakuum von 0 bis 300 mbar. Hierbei wird der Druck von bis zu 500 mbar auf die unter dem genannten Vakuum befindlichen Schichten des Aufbaus ausgeübt. Beispielsweise kann der Druck auf eine Platte aufgebracht werden, die auf die dem Vakuum ausgesetzten Schichten wirkt. Ohne auf eine bestimmte Theorie Bezug zu nehmen wird angenommen, dass durch das Aufbringen des Acrylats enthaltend Epoxigruppen in Pulverform auf die Gewebe zunächst vom Pulver nicht verlegte Entlüftungskanäle in den Geweben verbleiben, welche bei Anwenden des Vakuums dazu beitragen, Lufteinschlüsse im laminierten Verbundmaterial praktisch zur Gänze zu vermeiden.

Gemäß einer weiteren vorteilhaften Ausführungsform der Erfindung werden die Glasfasern des ersten und zweiten Gewebes vor ihrem Auflegen zumindest teilweise mit einem Finish als Haftvermittler überzogen. Da das Finish als Haftvermittler dient, wird die Verbindung zwischen den Glasfasern und dem pulverförmigen Acrylat enthaltend Epoxigruppen verbessert.

Um die Verbindung zwischen den Glasfasern und dem pulverförmigen Acrylat enthaltend Epoxigruppen weiter zu verbessern, wird das erste und zweite Gewebe nach dem jeweiligen Aufbringen des pulverförmigen Acrylats enthaltend Epoxigruppen in einem Temperaturbereich von 70 bis 120°C, vorzugsweise in einem Temperaturbereich von 85 bis 110°C und besonders bevorzugt bei 100°C und bei einem Druck von bis zu 500 mbar getempert.

Besonders vorteilhaft ist es, wenn auf das erste und zweite Gewebe pulverförmiges Acrylat enthaltend Epoxigruppen mit einer Korngröße im Bereich von 10 bis 500 µm, vorzugsweise im Bereich von 25 bis 100 µm und besonders bevorzugt im Bereich von 40 bis 50 µm aufgebracht wird. Durch eine geeignete Wahl der Korngröße ist es möglich, dass das auf das Gewebe aufgetragene Pulver teilweise in die Maschenöffnungen des Gewebes eindringt und somit weder im Falle zu kleiner Körner übermäßig durchrieselt, noch im Falle zu großer Körner ausschließlich auf dem Gewebe und über den Maschen zu liegen kommt. Auf diese Weise wird die Haftung zwischen dem Pulver und dem Gewebe zusätzlich verbessert.

Wenn auf das erste und zweite Gewebe pulverförmiges Acrylat enthaltend Epoxigruppen mit einem nach dem Laminieren im Wesentlichen gleichen optischen Brechungsindex wie jener der Glasfasern aufgebracht wird, wird ein Verbundmaterial mit besonders hoher Transparenz und somit ein Photovoltaik-Paneel mit entsprechend hohem Wirkungsgrad erhalten.

Es sei darauf hingewiesen, dass das Photovoltaik-Paneel sowohl für die Umwandlung von Licht, das auf die der Sonneneinstrahlung zugewandte Seite des Paneels (Vorderseite) fällt, als auch von allfälligem Licht, das auf die gegenüberliegende zur Sonneneinstrahlung abgewandte Seite (Rückseite) fällt, in elektrische Energie verwendet werden kann. Dies wird unter anderem durch das transparente Verbundmaterial sowohl an der der Sonneneinstrahlung zugewandten Seite als auch an der der Sonneneinstrahlung abgewandten Seite ermöglicht. Die Paneele können in nahezu beliebiger Form hergestellt werden. Insbesondere ist das Paneel biegbar und weist einen Biegeradius von 300 mm oder größer auf. Beispielsweise wurde ein erfindungsgemäß gefertigtes Paneel mit einer Leistung von 240 Wp (60 Zellen) an einer sich drehenden Säule mit einem Durchmesser von 1000 mm montiert. Die Paneele können auf festen oder auf flexiblen Untergründen montiert werden. Paneele gemäß der Erfindung weisen beispielsweise bei einer Breite von 1 m und einer Länge von 2 m ein Gewicht von weniger als 4 kg auf. Bei Verwendung von Wafern (Photovoltaik-Zellen) mit einer Dicke von 0,2 mm weisen die Paneele beispielsweise eine Dicke von etwa 1 mm auf. Die mechanische Festigkeit dieser Paneele wurde mit 111,9 N/mm² für die Zugbelastung gemessen. Die Biegefestigkeit wurde mit etwa 168,6 N/mm² gemessen.

Ein weiteres Paneel mit einer Dicke von 1,2 mm und einer Größe von 340 x 515 mm, bestehend aus 6 Zellen mit einer Ableitung aus Kupfer-Geflecht und 24W elektrischer Leistung bei Standard Testbedingungen, wies ein Gewicht von 315 g auf.

Ein anderes Paneel mit einer Dicke von 1,1 mm und einer Fläche von 980 mm x 1678 mm, bestehend aus 60 Wafern, die über entsprechende Kontakte miteinander verknüpft waren, mit einer Leistung von 240 Wp bei Standard Testbedingungen, wies ein Gewicht von 2,9 kg auf.

Erfindungsgemäße Paneele weisen bei flächiger Füllung mit photovoltaisch aktiven Elementen zwischen 1 kg/m² und 9 kg/m², vorzugsweises unter 2,5 kg/m² auf. Die Dicke der Paneele beträgt vorzugsweise zwischen 0,5 mm und 3 mm, insbesondere unter 1 mm, wenn die Dicke der photovoltaisch aktiven Materialien 0,2 mm beträgt. Die Paneele können mit Abmessungen von mehreren Metern in der Länge und mehreren Metern in der Breite hergestellt werden, wobei die bevorzugte Größe zwischen 1 und 3 Metern in der Länge und zwischen 0,5 und 2 Metern in der Breite beträgt.

Ein Beispiel für Glycidylmethacrylat ist Tiger Drylac© 250/00108 clear von TIGER Drylac U.S.A., Inc.. Beispiele für die Glasfasergewebe sind
- Ein Glasfilamentgewebe mit 163 g/m², an der dem Licht zugewandten Seite des Paneels, mit Kett- und Schussgarn EC9 68 aus E-Glas mit Endlosfasern mit einem Filamentdurchmesser von 9 µm und einer Feinheit von 68 tex = 68 g/1000m
- Ein Glasfilamentgewebe mit 390 g/m² (Style 1989), an der dem Licht abgewandten Seite des Paneels, mit einem Kettgarn EC9 68 x 5t0 aus E-Glas mit Endlosfasern mit einem Filamentdurchmesser von 9 µm und einer Feinheit von 68 tex, wobei 5 Garne nicht verdrillt zu einem zusammengelegt sind, und mit einem Schussgarn EC9 272 aus E-Glas mit Endlosfasern mit einem Filamentdurchmesser von 9 µm und einer Feinheit von 272 tex.

Die Erfindung wird im Folgenden anhand von bevorzugten, nicht einschränkenden Ausführungsbeispielen unter Bezugnahme auf die Zeichnung noch weiter erläutert.

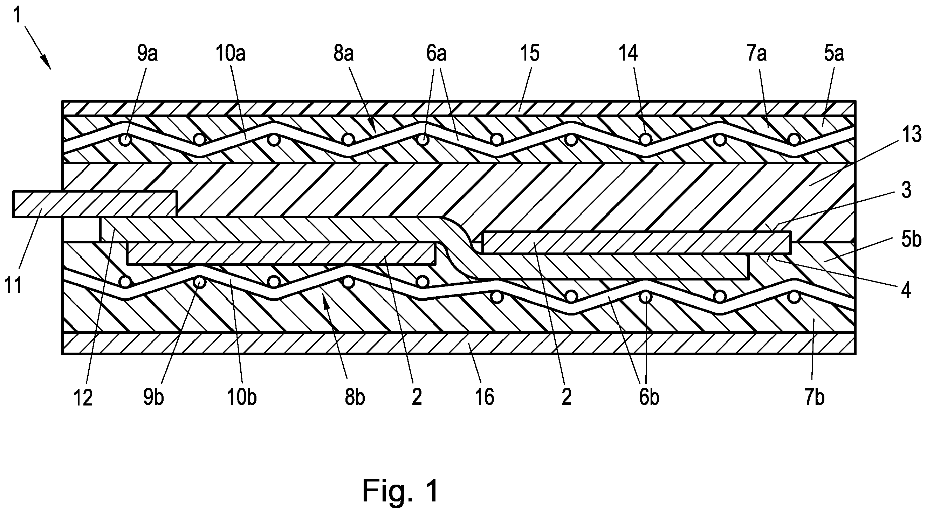

Fig. 1 zeigt eine Querschnittsansicht eines Photovoltaik-Paneels gemäß der Erfindung.

Fig. 1 zeigt insbesondere ein Photovoltaik-Paneel 1 mit zwei Solarzellen 2, welche zumindest an ihrer dem Licht zugewandten Seite 3 und ihrer gegenüberliegenden, dem Licht abgewandten Seite 4 mit einem transparenten Verbundmaterial 5a, 5b bedeckt sind. Das Verbundmaterial 5a, 5b ist ein mit Glasfasern 6a, 6b verstärkter Kunststoff 7a, 7b auf Basis eines Acrylats enthaltend Epoxigruppen. Die Glasfasern 6a an der dem Licht zugewandten Seite 3 der Solarzellen 2 sind zu einem ersten Gewebe 8a mit einem Kettgarn 9a und einem Schussgarn 10a ausgebildet. Ebenso sind die Glasfasern 6b an der dem Licht abgewandten Seite 4 der Solarzellen 2 zu einem zweiten Gewebe 8b mit einem Kettgarn 9b und einem Schussgarn 10b ausgebildet. Obwohl die Glasfasern 6a und 6b bzw. die Gewebe 8a und 8b in gleicher Größe bzw. Stärke dargestellt sind, soll dies keinesfalls als Einschränkung verstanden werden. Selbstverständlich können die Glasfasern 6a und 6b und somit auch die Gewebe 8a und 8b unterschiedliche Durchmesser bzw. Dicken aufweisen. Insbesondere ist es möglich, mehrere erste Gewebe 8a bzw. mehrere zweite Gewebe 8b übereinander anzuordnen um insgesamt stärkere Gewebeschichten zu erhalten. Zudem ist der Querschnitt der Glasfasern 6a, 6b nicht auf die dargestellte Kreisform beschränkt. Die Solarzellen 2 weisen eine elektrische Anschlussleitung 11 auf und sind über eine Verbindungsleitung 12 miteinander elektrisch verbunden. Wie weiters ersichtlich ist, ist zwischen der dem Licht zugewandten Seite 3 der Solarzellen 2 und dem Verbundmaterial 5a eine Schicht 13 aus Ethylenvinylacetat angeordnet. Die Glasfasern 6a, 6b sind mit einem Finish 14, der als Haftvermittler dient, überzogen. Zudem weist das Paneel 1 an seiner dem Licht zugewandten Vorderseite eine ETFE (Ethylen-Tetrafluorethylen) Folie 15 und an der dem Licht abgewandten Rückseite eine Folie 16 zum Schutz vor Umwelteinflüssen, insbesondere zum Schutz vor Feuchtigkeit und UV-Strahlung, sowie zur elektrischen Isolation auf. Ein Beispiel für die Folie 16 ist 500 DUN-Solar™EPE sw, von DUNMORE Europe GmbH, Deutschland, auf Basis von Polyehylenterephthalat.

## Patentansprüche

1. Photovoltaik-Paneel (1) mit zumindest einer Solarzelle (2), welche zumindest an ihrer dem Licht zugewandten Seite (3) und ihrer gegenüberliegenden, dem Licht abgewandten Seite (4) mit einem transparenten Verbundmaterial (5a, 5b) bedeckt ist, **dadurch gekennzeichnet, dass** das Verbundmaterial (5a, 5b) ein mit Glasfasern (6a, 6b) verstärkter Kunststoff (7a, 7b) auf Basis eines Acrylats enthaltend Epoxigruppen ist, wobei die Glasfasern (6a) an der dem Licht zugewandten Seite (3) der zumindest einen Solarzelle (2) zu einem Gewebe (8a) mit einem Gewicht im Bereich von 50 bis 300 g/m², vorzugsweise im Bereich von 100 bis 200 g/m² und besonders bevorzugt im Bereich von 160 bis 165 g/m² ausgebildet sind.

2. Photovoltaik-Paneel (1) nach Anspruch 1, **dadurch gekennzeichnet, dass** das Acrylat enthaltend Epoxigruppen Glycidylmethacrylat ist.

3. Photovoltaik-Paneel (1) nach Anspruch 1 oder 2, **dadurch gekennzeichnet, dass** die Glasfasern (6a, 6b) einen Filamentdurchmesser im Bereich von 3 bis 15 µm, vorzugsweise im Bereich von 6 bis 12 µm und besonders bevorzugt von 9 µm aufweisen.

4. Photovoltaik-Paneel (1) nach einem der Ansprüche 1 bis 3, **dadurch gekennzeichnet, dass** das Gewebe (8a) einen Kettgarn (9a) und einen Schussgarn (10a) mit einer Feinheit im Bereich von 30 bis 120 tex, vorzugsweise im Bereich von 45 bis 100 tex und besonders bevorzugt im Bereich von 60 bis 70 tex aufweist.

5. Photovoltaik-Paneel (1) nach einem der Ansprüche 1 bis 4, **dadurch gekennzeichnet, dass** die Glasfasern (6b) an der dem Licht abgewandten Seite (4) der zumindest einen Solarzelle (2) zu einem Gewebe (8b) mit einem Gewicht im Bereich von 100 bis 600 g/m², vorzugsweise im Bereich von 200 bis 500 g/m² und besonders bevorzugt von 390 g/m² ausgebildet sind.

6. Photovoltaik-Paneel (1) nach Anspruch 5, **dadurch gekennzeichnet, dass** das Gewebe (8b) einen aus 1 bis 9, vorzugsweise 3 bis 7, besonders bevorzugt 5 zusammengelegten Garnen bestehenden Kettgarn (9b) mit einer Feinheit der Garne im Bereich von 30 bis 120 tex, vorzugsweise im Bereich von 45 bis 100 tex und besonders bevorzugt im Bereich von 60 bis 70 tex und einen Schussgarn (10b) mit einer Feinheit im Bereich von 100 bis 450 tex, vorzugsweise im Bereich von 200 bis 350 tex und besonders bevorzugt im Bereich von 270 bis 280 tex aufweist.

7. Verfahren zur Herstellung eines Photovoltaik-Paneels (1) nach einem der Ansprüche 1 bis 6 umfassend die Schritte:
- Aufbringen von pulverförmigem Acrylat enthaltend Epoxigruppen auf ein erstes Gewebe (8a) aus Glasfasern (6a),
- Auflegen zumindest einer Solarzelle (2) und mit der Solarzelle (2) verbundener elektrischer Anschlussleitungen (11) sowie allfälliger mehrere Solarzellen (2) verbindende Verbindungsleitungen (12) auf das pulverförmige Acrylat enthaltend Epoxigruppen oder auf eine auf das pulverförmige Acrylat enthaltend Epoxigruppen aufgebrachte Schicht (13) aus Ethylenvinylacetat,
- Auflegen eines zweiten Gewebes (8b) aus Glasfasern (6b) auf die zumindest eine Solarzelle (2), die Anschlussleitungen (11) und die allfälligen Verbindungsleitungen (12),
- Aufbringen von pulverförmigem Acrylat enthaltend Epoxigruppen auf das zweite Gewebe (8b), und
Laminieren des gesamten Aufbaus.

8. Verfahren nach Anspruch 7, **dadurch gekennzeichnet, dass** als Acrylat enthaltend Epoxigruppen Glycidylmethacrylat aufgebracht wird.

9. Verfahren nach Anspruch 8, **dadurch gekennzeichnet, dass** das Laminieren in einem Temperaturbereich von 150 bis 200°C, bei einem Druck von bis zu 500 mbar und unter einem Vakuum von 0 bis 300 mbar erfolgt.

10. Verfahren nach einem der Ansprüche 7 bis 9, **dadurch gekennzeichnet, dass** die Glasfasern (6a, 6b) des ersten und zweiten Gewebes (8a, 8b) vor ihrem Auflegen zumindest teilweise mit einem Finish (14) als Haftvermittler überzogen werden.

11. Verfahren nach einem der Ansprüche 7 bis 10, **dadurch gekennzeichnet, dass** das erste und zweite Gewebe (8a, 8b) nach dem jeweiligen Aufbringen des pulverförmigen Acrylats enthaltend Epoxigruppen in einem Temperaturbereich von 70 bis 120°C, vorzugsweise in einem Temperaturbereich von 85 bis 110°C und besonders bevorzugt bei 100°C und bei einem Druck von bis zu 500 mbar getempert wird.

12. Verfahren nach einem der Ansprüche 7 bis 11, **dadurch gekennzeichnet, dass** auf das erste und zweite Gewebe (8a, 8b) pulverförmiges Acrylat enthaltend Epoxigruppen mit einer Korngröße im Bereich von 10 bis 500 µm, vorzugsweise im Bereich von 25 bis 100 µm und besonders bevorzugt im Bereich von 40 bis 50 µm aufgebracht wird.

13. Verfahren nach einem der Ansprüche 7 bis 12, **dadurch gekennzeichnet, dass** auf das erste und zweite Gewebe (8a, 8b) pulverförmiges Acrylat enthaltend Epoxigruppen mit einem nach dem Laminieren im Wesentlichen gleichen optischen Brechungsindex wie jener der Glasfasern (6a, 6b) aufgebracht wird.

## Claims

1. A photovoltaic panel (1) with at least one solar cell (2) covered with a transparent composite material (5a, 5b) at least at a side (3) facing towards the light and an opposite side (4) facing away from the light, **characterized in that** the composite material (5a, 5b) is a plastic (7a, 7b) on the basis of an acrylate containing epoxy groups, reinforced with glass fibers (6a, 6b), wherein the glass fibers (6a) at the side of the at least one solar cell (2) facing towards the light are designed to form a fabric (8a) with a weight in the range of 50 to 300 g/m², preferably in the range of 100 to 200 g/m², and particularly preferred in the range of 160 to 165 g/m².

2. The photovoltaic panel (1) according to claim 1, **characterized in that** the acrylate containing epoxy groups is glycide methacrylate.

3. The photovoltaic panel (1) according to claims 1 or 2, **characterized in that** the glass fibers (6a, 6b) have a filament diameter in the range of 3 to 15 µm, preferably in the range of 6 to 12 µm, and particularly preferred of 9 µm.

4. The photovoltaic panel (1) according to any of claims 1 to 3, **characterized in that** the fabric (8a) comprises a warp yarn (9a) and a weft yarn (10a) with a yarn count in the range of 30 to 120 tex, preferably in the range of 45 to 100 tex, and particularly preferred in the range of 60 to 70 tex.

5. The photovoltaic panel (1) according to any of claims 1 to 4, **characterized in that** the glass fibers (6b) at the side (4) of the at least one solar cell (2) facing away from the light are designed to form a fabric (8b) with a weight in the range of 100 to 600 g/m², preferably in the range of 200 to 500 g/m², and particularly preferred of 390 g/m².

6. The photovoltaic panel (1) according to claim 5, **characterized in that** the fabric (8b) comprises a warp yarn (9b) consisting of 1 to 9, preferably 3 to 7, particularly preferred 5, joined yarns with a yarn count in the range of 30 to 120 tex, preferably in the range of 45 to 100 tex, and particularly preferred in the range of 60 to 70 tex, and a weft yarn (10b) with a yarn count in the range of 100 to 450 tex, preferably in the range of 200 to 350 tex, and particularly preferred in the range of 270 to 280 tex.

7. A method for manufacturing a photovoltaic panel (1) according to any of claims 1 to 6, comprising the steps of:
- applying powdered acrylate containing epoxy groups on a first fabric (8a) of glass fibers (6a),
- placing at least one solar cell (2) and electrical branch lines (11) connected with the solar cell (2) as well as possible connection lines (12) connecting a plurality of solar cells (2) on the powdered acrylate containing epoxy groups or on a layer (13) of ethylene vinyl acetate applied on the powdered acrylate containing epoxy groups,
- placing a second fabric (8b) of glass fibers (6b) on the at least one solar cell (2), the branch lines (11) and the possible connection lines (12),
- applying powdered acrylate containing epoxy groups on the second fabric (8b), and
- laminating the entire structure.

8. The method according to claim 7, **characterized in that** glycidyl methacrylate is applied as an acrylate containing epoxy groups.

9. The method according to claim 8, **characterized in that** laminating takes place in a temperature range of 150 to 200°C, at a pressure of up to 500 mbar and under a vacuum of 0 to 300 mbar.

10. The method according to any of claims 7 to 9, **characterized in that** the glass fibers (6a, 6b) of the first and second fabrics (8a, 8b) are coated at least partially with a finish (14) as an adhesion agent prior to their placing.

11. The method according to any of claims 7 to 10, **characterized in that** the first and second fabrics (8a, 8b) are tempered, after the respective application of the powdered acrylate containing epoxy groups, in a temperature range of 70 to 120°C, preferably in a temperature range of 85 to 110°C, and particularly preferred at 100°C and at a pressure of up to 500 mbar.

12. The method according to any of claims 7 to 11, **characterized in that** powdered acrylate containing epoxy groups is applied on the first and second fabrics (8a, 8b) with a grain size in the range of 10 to 500 µm, preferably in the range of 25 to 100 µm, and particularly preferred in the range of 40 to 50 µm.

13. The method according to any of claims 7 to 12, **characterized in that** powdered acrylate containing epoxy groups is applied on the first and second fabrics (8a, 8b) with an optical refraction index substantially equal to that of the glass fibers (6a, 6b) after laminating.

## Revendications

1. Panneau photovoltaïque (1), comportant au moins une cellule solaire (2), qui au moins sur sa face (3) dirigée vers la lumière et sur sa face opposée (4), opposée à la lumière, est revêtue d'un matériau composite transparent (5a, 5b), **caractérisé en ce que** le matériau composite (5a, 5b) est un matériau plastique (7a, 7b), renforcé par des fibres de verre (6a, 6b), à base d'un acrylate comprenant des groupes époxy, les fibres de verre (6a) étant, sur la face (3) dirigée vers la lumière, de l'au moins une cellule solaire (2), configurées pour donner un tissu (8a) ayant une masse surfacique comprise dans la plage de 50 à 300 g/m², de préférence dans la plage de 100 à 200 g/m² et d'une manière particulièrement préférée dans la plage de 160 à 165 g/m².

2. Panneau photovoltaïque (1) selon la revendication 1, **caractérisé en ce que** l'acrylate contenant des groupes époxy est le méthacrylate de glycidyle.

3. Panneau photovoltaïque (1) selon la revendication 1 ou 2, **caractérisé en ce que** les fibres de verre (6a, 6b) présentent un diamètre de filament compris dans la plage de 3 à 15 µm, de préférence dans la plage de 6 à 12 µm, et d'une manière particulièrement préférée de 9 µm.

4. Panneau photovoltaïque (1) selon l'une des revendications 1 à 3, **caractérisé en ce que** le tissu (8a) présente un fil de chaîne (9a) et un fil de trame (10a) ayant une finesse comprise dans la plage de 30 à 120 tex, de préférence dans la plage de 45 à 100 tex et d'une manière particulièrement préférée dans la plage de 60 à 70 tex.

5. Panneau photovoltaïque (1) selon l'une des revendications 1 à 4, **caractérisé en ce que** les fibres de verre (6b), sur le côté (4) opposé à la lumière de l'au moins une cellule solaire (2), sont configurées pour donner un tissu (8b) ayant une masse surfacique comprise dans la plage de 100 à 600 g/m², de préférence dans la plage de 200 à 500 g/m² et d'une manière particulièrement préférée de 390 g/m².

6. Panneau photovoltaïque (1) selon la revendication 5, **caractérisé en ce que** le tissu (8b) présente un fil de chaîne (9b) constitué de 1 à 9, de préférence de 3 à 7, d'une manière particulièrement préférée de 5 fils assemblés, ayant une finesse des fils comprise dans la plage de 30 à 120 tex, de préférence dans la plage de 45 à 100 tex et d'une manière particulièrement préférée dans la plage de 60 à 70 tex, et un fil de trame (10b) ayant une finesse comprise dans la plage de 100 à 450 tex, de préférence dans la plage de 200 à 350 tex et d'une manière particulièrement préférée dans la plage de 270 à 280 tex.

7. Procédé de fabrication d'un panneau photovoltaïque (1) selon l'une des revendications 1 à 6, comprenant les étampes :
- application, sur un premier tissu (8a) constitué de fibres de verre (6a), d'un acrylate pulvérulent contenant des groupes époxy,
- dépôt d'au moins une cellule solaire (2) et de lignes de raccordement électrique (11), raccordées à la cellule solaire (2), ainsi que d'éventuelles lignes de liaison (12) reliant plusieurs cellules solaires (2) sur l'acrylate pulvérulent contenant des groupes époxy, ou sur une couche (13), en éthylène-acétate de vinyle, appliquée sur l'acrylate pulvérulent contenant des groupes époxy,
- dépôt d'un deuxième tissu (8b) constitué de fibres de verre (6b) sur l'au moins une cellule solaire (2), les lignes de raccordement (11) et les éventuelles lignes de liaison (12),
- application d'un acrylate pulvérulent contenant des groupes époxy sur le deuxième tissu (8b), et
contrecollage de la structure totale.

8. Procédé selon la revendication 7, **caractérisé en ce qu'**on applique en tant qu'acrylate contenant des groupes époxy du méthacrylate de glycidyle.

9. Procédé selon la revendication 8, **caractérisé en ce que** le contrecollage est réalisé sur une plage de températures de 150 à 200°C, sous une pression allant jusqu'à 500 mbar et sous un vide de 0 à 300 mbar.

10. Procédé selon l'une des revendications 7 à 9, **caractérisé en ce que** les fibres de verre (6a, 6b) du premier et du deuxième tissus (8a, 8b) sont, avant leur dépôt, revêtus au moins partiellement d'un apprêt (14) en tant que promoteur d'adhérence.

11. Procédé selon l'une des revendications 7 à 10, **caractérisé en ce que** le premier et le deuxième tissus (8a, 8b) sont, après le dépôt, dans chaque cas, de l'acrylate pulvérulent contenant des groupes époxy, portés à l'équilibre de température dans la plage de températures de 70 à 120°C, de préférence dans la plage de températures de 85 à 110°C et d'une manière particulièrement préférée à 100°C et sous une pression allant jusqu'à 500 mbar.

12. Procédé selon l'une des revendications 7 à 11, **caractérisé en ce qu'**on applique sur le premier et sur le deuxième tissus (8a, 8b) un acrylate pulvérulent contenant des groupes époxy, ayant une granulométrie comprise dans la plage de 10 à 500 µm, de préférence dans la plage de 25 à 100 µm et d'une manière particulièrement préférée dans la plage de 40 à 50 µm.

13. Procédé selon l'une des revendications 7 à 12, **caractérisé en ce qu'**on applique sur le premier et sur le deuxième tissus (8a, 8b) un acrylate pulvérulent contenant des groupes époxy ayant un indice de réfraction optique, après le contrecollage, pour l'essentiel égal à celui des fibres de verre (6a, 6b).
